# EUROPEAN PATENT SPECIFICATION

(11) **EP 0 196 975 B1**
(45) Date of publication and mention of the grant of the patent: **26.05.1993**
(21) Application number: 86400695.2
(22) Date of filing: 28.03.1986
(51) Int. Cl.: H01L 45/02

(54) **Solid electromagnetic wave amplifier**
Festkörperverstärker für elektromagnetische Wellen
Amplificateur à ondes électromagnétiques du type à l'état solide

(30) Priority: 28.03.1985 JP 62078/85
(43) Date of publication of application: 08.10.1986
(73) Proprietor: HOKKAIDO UNIVERSITY, Sapporo City Hokkaido (JP)
(72) Inventor: Hasegawa, Hideki, Ebetsu City Hokkaido (JP); Ohno, Hideo, Sapporo City Hokkaido (JP)
(74) Representative: Phélip, Bruno

(56) References cited:
- US-A- 3 436 666
- US-A- 3 639 851
- JOURNAL OF APPLIED PHYSICS, vol. 46, no. 9, September 1975, pages 3925-3933, American Institute of Physics; J. THIENNOT: "Traveling-wave amplification by interaction with a current in a semiconductor"
- LE JOURNAL DE PHYSIQUE, vol. 33, nos. 8/9, August/September 1972, pages 781-786; J. THIENNOT: "L'effet de la charge électrique de surface sur le gain de l'amplificateur à onde progressive à l'état solide"
- Physics of Semiconductor Devices, S.M. Sze, John Wiley & Sons, US, 1981, p. 351

## Description

The present invention relates to a solid electromagnetic wave amplifier used in the amplification of ultra high frequency electromagnetic wave in an order up to about 100 GHz.

By a recent remarkable development of the Si-integrated circuits, highly technical life utilizing dense information becomes realistic and this necessitates for the processing of more and more increasing amount of information and the media for the transmission of the same. This imposes a requirement to make the electric signal to be processed in a range up to the ultra high frequency. On the other hand, ever since the invention of the transistors, the solidification of the electronic elements becomes a definite technical tendency in this field. At present, there are still two vaccum tube elements, which can not be substituted by the solid electronic elements. The first one of the same is the Brown tube for the display purpose and the second one is the ultra high frequency high power vacuum tube such as the progressive wave tube. The latter is to utilize inter-action between the electrons travelling in vacuum and the delayed wave of the electromagnetic field and it can produce a substantially high power. This is by a reason that the inter-action between the electrons and the electromagnetic field is not limited in a very small space like that of a triode, but the inter-action is carried out gradually according to the propagation of the electromagnetic wave.

This progressive wave type amplification results the same effects in the solid elements compared with the field effect elements. By this reason, solid type progressive wave amplifiers utilizing electrons (or holes) in solid body have been suggested since long time and related calculations had also been carried out. Nevertheless, it has not been realized into practice up to present.

This may be by a reason that in the conventional solid type amplifiers using inter-action between the carrier wave of electrons or holes in the solid element and the electromagnetic wave, the amplitude of the carrier wave which inter-acts with the electromagnetic field decreases by the diffusion effect of the carrier wave into the bulk on the solid body so that a sufficient inter-action is not realized. Accordingly, an invention of a solid type electromagnetic wave amplifier having structure able to prevent such diffusion might solve the presently unprogressed solidification of ultra high frequency high power element and thus it may contribute miniaturization and decreasing the weight of microwave communication and radar equipments which may result drastical enlargement of applicable field of such techniques.

The prior art document US-A-3 639 851 provides an ultrahigh-frequency semiconductor amplifier having a structure consisting of a semiconductor layer applied to a substrate. The semiconductor layer is, for example, gallium arsenide, and the substrate is semiinsulating gallium arsenide, upon which the active layer is deposited by epitaxial techniques. An insulating layer is in contact with said semiconductor layer. Furthermore it is indicated that the thickness of said semiconductor layer should be small compared with the delayed wave length in a line. It should be longer than the Debye length.

### (Object of the Invention)

The present invention is to mitigate the aforementioned drawback of the conventional solidified amplifiers by introducing a structure for preventing carrier wave diffusion and to realize a solid electromagnetic wave amplifier able to amplify the electromagnetic wave of super high frequency up to 100 GHz order.

For a better understanding of the invention, reference is made to the accompanying drawings, in which:
Fig. 1 is a characteristic diagram for showing actual embodiment of losses caused by progressive diffusion of the carrier wave in a semiconductor body;
Fig. 2 is an explanatory diagram for showing the principle of prevention of the carrier wave diffusion using a thin semiconductor film;
Fig. 3 is an explanatory diagram for showing principle of the carrier wave diffusion preventing structure using a potential barrier for the carrier wave;
Fig. 4 is an explanatory diagram for showing potential distribution along the direction of depth of the carrier wave diffusion preventing structure shown in Fig. 3;
Fig. 5 is a diagram for explaining the principle of a more practical embodiment of the carrier wave diffusion preventing structure by an electric field; and
Fig. 6 is an explanatory diagram for showing the potential distribution along the direction of depth of the structure shown in Fig. 5.

The present invention is to overcome the loss resulting from the decrease of amplitude of the carrier wave inter-acting with the electromagnetic wave by the diffusion into semiconductor body by introducing the carrier wave diffusion preventing structure.

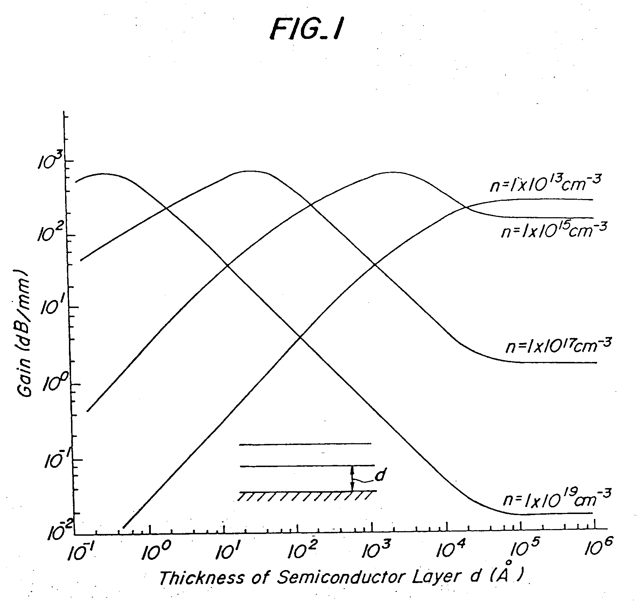

Practical embodiment of losses caused by the diffusion of the carrier wave in the semiconductor body is shown in Fig. 1.

Fig. 1 shows the relation between the gain in ordinate and the thickness of the semiconductor in abscissa. As can be seen clearly from the drawing, in the region having practical carrier concentration of n>16¹⁶ cm⁻³, if the thickness of the semiconductor is larger than the Debye's screening length L_{D}, the attenuation caused from the diffusion of the carrier wave becomes remarkable and the gain decreases remarkably. Herein, the term of Debye's screening length L_{D} is defined by the following equation. 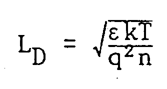
wherein;
- ε =: dielectric constant (13 ε₀)
- k =: Boltzmann constant
- T =: absolute temperature
- q =: unit charge
- n =: carrier density
The present invention as defined in the claims is to remove the carrier diffusion phenomenon by using the following 3 kinds of methods.
(1) to use semiconductor thin film.
(2) to use potential barrier for the carrier wave.
(3) to use confinement action of the electric field.

The invention will now be described by referring to the accompanying drawings.

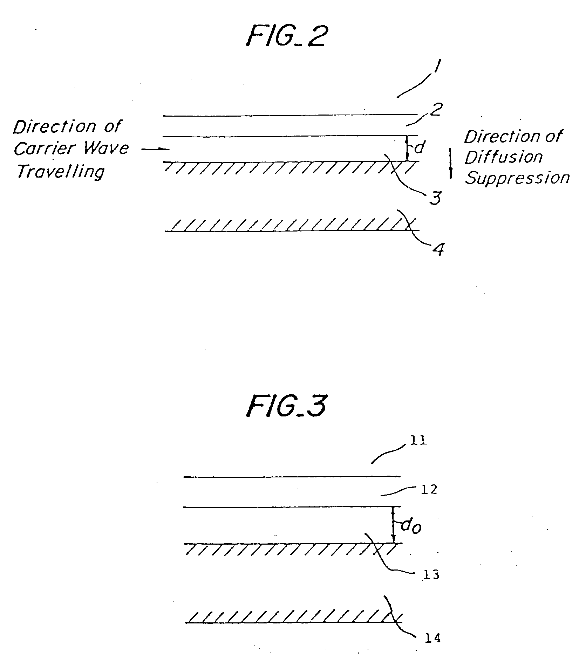

Fig. 2 shows an embodiment using a thin semiconductor film. In Fig. 2, the reference numeral 1 designates a space in which the electromagnetic field inter-acting with the carrier wave exists, 2 is an insulating film for protecting the semiconductor surface, 3 is the thin semiconductor film for producing the carrier wave, 4 is a semi-insulating substrate for supporting the thin semiconductor film and d shows the thickness of the thin semiconductor film.

In this condition, the diffusion of the carrier wave is automatically suppressed since the thin semiconductor film has a definite limit in the thickness. The thickness d of the thin semiconductor film is preferred to be of the order of Debye's screening length L_{D} as has been explained with respect to Fig. 1. Furthermore, the thin semiconductor film used in this purpose is preferred to have a high carrier mobility in order to raise the efficiency of the amplification. Under, this object, it is preferred to use the compound semiconductor typically represented by GaAs and InP and mixed crystals thereof. However, Si may be used in view of its highly established processing technique.

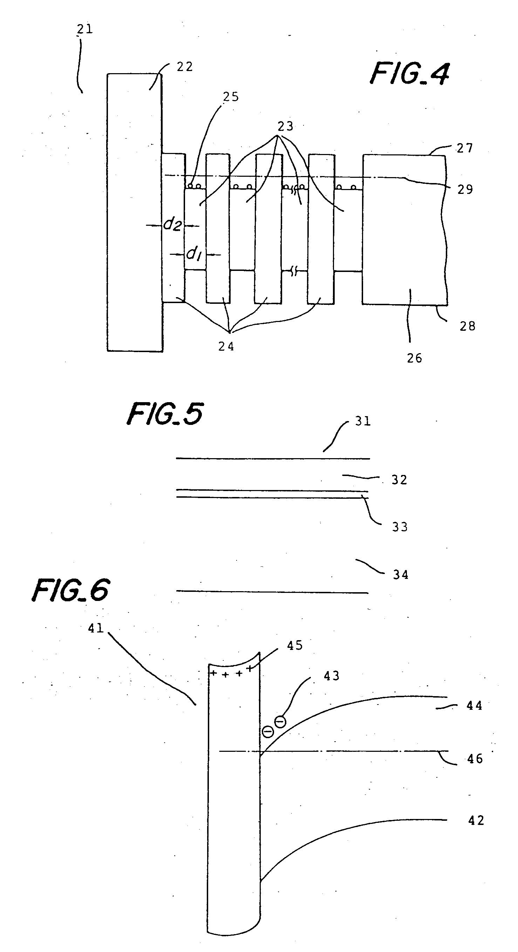

Fig. 3 shows an embodiment in which the potential barrier against the carrier wave is used. Herein, the discontinuity of the band at the hetero junction of the semiconductor is used as the barrier for the confinement.

In Fig. 3, the reference numeral 11 designates a space in which the electromagnetic field inter-acting with the carrier wave exists, 12 is an insulating film for protecting the semiconductor surface, 13 is the semiconductor layer having hetero junction for producing the carrier wave,14 is a semi-insulating semiconductor substrate for supporting the semiconductor layer, and d₀ is the thickness of the semiconductor layer having the hetero junction.

Fig. 4 shows the potential distribution in the direction of the thickness of the structure shown in Fig. 3. In Fig. 4, reference numeral 21 designates a space in which an electromagnetic field inter-acting with the carrier wave exists, 22is an insulating film for protecting the semiconductor surface, 23 is a low potential semiconductor layer having the thickness d₁ in the hetero junction, 24 is a high potential semiconductor layer having the thickness d₂ of the hetero junction, 25 is an electron, 26 is a semi-insulating substrate for supporting the thin semiconductor layers, and the line indicated by the reference numeral 27 is the lower edge of the conduction band of the semiconductor, 28 is the upper end of the valence band of the semiconductor and line 29 indicates Fermi level. In this condition, the carriers are confined in the respective low potential semiconductor layers (23) by the barriers accompanying with the hetero junctions. The thickness d₁ of the low potential semiconductor layers is preferred to be less than the Debye's screening length. It is better to arrange in a multi-layer construction by stucking number of layers as shown in Fig. 4, by making the thickness of each layer sufficiently thin so as to increase the gain of the device. In this case, the sum of thickness d₁ of the stucked layers may better to exceed the Debye's screening length and the thickness d₂ is better to be thin in a range that the carriers can not move by the tunnel effect. In this embodiment, it is more convenient to additionally use the so called selective doping structure for the portion 24 to increase the mobility of the carriers to further improve the efficiency. The semiconductors to be used are better to have high carrier mobility for improving the efficiency of the amplification. From this view point, it is preferred to use compound semiconductors typically represented by GaAs and InP and the combination of the mixed crystals such as for instance AℓGaAs/GaAs, InAs/GaSb, InP/GaInAs and the like. It is also possible to use combination of Si and Ga.

Fig. 5 is an embodiment using confinement action of the electric field. In Fig. 5, reference numeral 31 is a space in which the electromagnetic field inter-acting with the carrier wave exists, 32 is an insulating film for protecting the semiconductor surface and for forming the channel layer, 33 is a channel layer for accumulating (inverting) carriers at the surface of the semiconductor and 34 is the semiconductor layer.

Fig. 6 shows potential distribution along the depth of the structure shown in Fig. 5. In Fig. 6, reference numeral 41 designates a space in which the electromagnetic wave inter-acting with the carrier wave exists, 42 is an insulating film for protecting the semiconductor surface and for forming channel layer, 43 is the channel layer for accumulating (inverting) carriers at the surface of the semiconductor, 44 is the semiconductor layer, 45 shows positive ion caused by doping in the insulating film for forming the accumulating layer at the surface of the semiconductor (in this regard, it is also possible to use gate electrodes for forming the accumulating layer), and 46 shows Fermi level.

In this structure, the electrons in the accumulating layer formed in the surface of the semiconductor are confined by the electric field in the semiconductor layer 44 produced from the positive ions 45 shown in Fig. 6, by the insulating film 42 and by the potential barrier in the semiconductor layer 44, namely the electrons are confined in a very narrow region and the diffusion into the bulk of the semiconductor is suppressed.

The semiconductors used in this structure are preferred to have high carrier mobility in view of improving the efficiency of the amplification and to have less surface level. In this respect, it is preferred to use compound semiconductors such as represented by InP and mixed crystals thereof such as GaInAs and the like. But Si can also be used. The structure may be combined with hetero structure.

The present invention is to overcome the loss due to attenuation of the amplitude of the carrier wave inter-acting with the electromagnetic wave by the diffusion of the carrier into semiconductor body by introducing a structure for the confinement of the carrier wave.

The invention uses as the confinement structure the following 3 kinds:
(1) Thin semiconductor film.
(2) Potential barrier for the carrier wave.
(3) The structure of constriction by the electric field.

## Claims

1. Solid state semiconductor type electromagnetic wave amplifier based on travelling wave interaction between a carrier wave and an electromagnetic wave comprising means for suppressing the power loss caused by the diffusion of the carrier wave in the said amplifier for operating at frequencies up to of the order of 100 GHz, said suppressing means including a semi-insulating substrate (4, 14, 26, 34), a barrier (3, 13, 23, 24, 33) formed on said substrate (4, 14, 26, 34) to prevent the carrier wave diffusion into said substrate (4, 14, 26, 34), said barrier comprising at least one nonmetallic semiconductor layer for producing the carrier wave, said layer having a thickness of the order of Debye's screening length, said barrier (33, 13, 23, 24, 33) being integrally joined, on its surface opposite to the substrate (4, 14, 26, 34), to an insulating layer (2, 12, 22, 32).

2. Solid state semiconductor type electromagnetic wave amplifier as claimed in the claim 1, characterised in that the barrier (23, 24) includes a plurality of heterojunctions of alternating layers of low potential material and a high potential material, the thickness of said low potential materials being less than Debye's screening length.

3. Solid state semiconductor type electromagnetic wave amplifier as claimed in the claims 1 or 2, characterised in that the barrier is a multipotential barrier formed by a plurality of heterojunctions of two different alternating materials, to prevent carrier wave diffusion into said substrat.

4. Solid state semiconductor type electromagnetic wave amplifier as claimed in claim 3, characterised in that said two different materials include a low potential material and a high potential material, each of said materials provided in a distinct layer.

5. Solid state semiconductor type electromagnetic wave amplifier as claimed in claim 3 characterised in that said materials are formed into a sandwich made up of multiple alternating layers of said high potential material and said low potential material.

## Patentansprüche

1. Verstärker für elektromagnetische Wellen vom Festkörper-Halbleiter-Typ auf der Basis der Wechselwirkung wandernder Wellen zwischen einer Trägerwelle und einer elektromagnetischen Welle,
umfassend Mittel zur Unterdrückung des durch die Diffusion der Trägerwelle in dem Verstärker verursachten Leistungsverlustes für einen Betrieb bei Frequenzen bis hinauf zu einer Größenordnung von 100 GHz,
wobei die Unterdrückungs-Mittel ein halbisolierendes Substrat (4, 14, 26, 34), eine auf dem Substrat (4, 14, 26, 34) gebildete Sperre (3, 13, 23, 24, 33), um die Diffusion der Trägerwelle in das Substrat (4, 14, 26, 34) zu verhindern, umfassen, wobei die Sperre wenigstens eine Schicht aus einem nichtmetallischen Halbleiter zur Erzeugung der Trägerwelle umfaßt, wobei die Schicht eine Dicke der Größenordnung der Debye-Abschirmungslänge hat, wobei die Sperre (3, 13, 23, 24, 33) auf ihrer dem Substrat (4, 14, 26, 34) abgewandten Seite mit einer Isolierschicht (2, 12, 22, 32) integriert verbunden ist.

2. Verstärker für elektromagnetische Wellen vom Festkörper-Halbleiter-Typ nach Anspruch 1, dadurch gekennzeichnet, daß die Sperre (23, 24) eine Mehrzahl Heteroübergänge alternierender Schichten aus einem Material niedrigen Potentials und einem Material hohen Potentials umfaßt, wobei die Dicke der Schicht aus dem Material niedrigen Potentials kleiner als die Debye-Abschirmungslänge ist.

3. Verstärker für elektromagnetische Wellen vom Festkörper-Halbleiter-Typ nach den Ansprüchen 1 oder 2, dadurch gekennzeichnet, daß die Sperre eine Multipotential-Sperre ist, die aus einer Mehrzahl von Heteroübergängen zweier verschiedener, alternierender Materialien gebildet wird, um eine Diffusion der Trägerwelle in das Substrat zu verhindern.

4. Verstärker für elektromagnetische Wellen vom Festkörper-Halbleiter-Typ nach Anspruch 3, dadurch gekennzeichnet, daß die beiden verschiedenen Materialien ein Material niedrigen Potentials und ein Material hohen Potentials umfassen, wobei jedes der Materialien in einer gesonderten Schicht bereitgestellt wird.

5. Verstärker für elektromagnetische Wellen vom Festkörper-Halbleiter-Typ nach Anspruch 3, dadurch gekennzeichnet, daß die genannten Materialien in Form eines Sandwich aus mehreren alternierenden Schichten des Materials hohen Potentials und des Materials niedrigen Potentials ausgebildet werden.

## Revendications

1. Amplificateur à ondes électromagnétiques du type à semiconducteur à l'état solide basé sur l'interaction d'une onde mobile entre une onde porteuse et une onde électromagnétique comprenant un moyen pour supprimer la perte de puissance provoquée par la diffusion de l'onde porteuse dans ledit amplificateur pour un fonctionnement à des fréquences allant jusqu'à 100 GHz, ledit moyen de suppression comprenant un substrat semi-isolant (4, 14, 26, 34), une barrière (3, 13 23, 24, 33) formée sur ledit substrat (4, 14, 26, 34) pour empêcher la diffusion d'onde porteuse dans ledit substrat (4, 14, 26, 34) ladite barrière comprenant au moins une couche non métallique à semiconducteur pour produire l'onde porteuse, ladite couche ayant une épaisseur de l'ordre de la longueur d'écran Debye, ladite barrière (33, 13, 23, 24, 33) étant solidarisée sur sa surface opposée au substrat (4, 14, 26, 34), à une couche isolante (2, 12, 22, 32).

2. Amplificateur à ondes électromagnétiques du type à semiconducteur à l'état solide selon la revendication 1, caractérisé en ce que la barrière (23, 24) comporte une pluralité d'hétérojonctions de couches alternées de matière à faible potentiel et de matière à potentiel élevé, l'épaisseur desdites matières à faible potentiel étant inférieure à la longueur d'écran Debye.

3. Amplificateur à ondes électromagnétiques du type à semiconducteur à l'état solide selon l'une des revendications 1 ou 2, caractérisé en ce que la barrière est une barrière multipotentiel formée par une pluralité d'hétérojonctions de deux matières alternées différentes, pour empêcher la diffusion d'onde porteuse dans ledit substrat.

4. Amplificateur à ondes électromagnétiques du type à semiconducteur à l'état solide selon la revendication 3, caractérisé en ce que lesdites deux matières différentes comprennent une matière à faible potentiel et une matière à potentiel élevé, chacune desdites matières étant prévue selon une couche distincte.

5. Amplificateur à ondes électromagnétiques du type à semiconducteur à l'état solide selon la revendication 3, caractérisé en ce que lesdites matières sont formées selon un sandwich constitué de multiples couches alternées de ladite matière à potentiel élevé et de ladite matière à faible potentiel.
